# EUROPEAN PATENT APPLICATION

(11) **EP 3 419 219 A1**
(43) Date of publication of application: **26.12.2018**
(21) Application number: 17753564.8
(22) Date of filing: 15.02.2017
(51) Int. Cl.: H04L 12/26, G05B 23/00

(54) **MONITORING CABLE CONNECTIONS USING ETHERNET-CONNECTION ESTABLISHMENT SIGNALS**

(30) Priority: 16.02.2016 RU 2016104972
(71) Applicant: OOO "UCABLE", Moscow 143026 (RU)
(72) Inventor: KHOZYAINOV, Boris Alekseevich, Korolev, 141077 (RU)
(74) Representative: Chimini, Francesco
(86) International application number: PCT/RU2017/000074
(87) International publication number: WO 2017/142440

(57) **Abstract**

The invention relates primarily to communication technologies. Its use allows cable connections monitoring without establishing a network connection, using Ethernet connection establishing signals. To achieve this technical result, they equip patch panel with either a generator, emulating Ethernet connection establishing signals or a receiver, perceiving Ethernet connection establishing signals.

## Description

### Sphere of the invention

The present invention relates primarily to communication technologies and can be used to monitor the patch panels cable connections.

### Background of the invention

There are various means of cable connections monitoring in the world, the main task of which is to understand how devices could be joined with each other by using the cable.

For example, in the US2006/0164998 application, the reflectometer (Time Domain Reflectometry) is used to analyze the newly emerging connections in the cable line.

The method and system, described in the RU2313800 patent, which has connection sensors on the patch panel, are also known. The sensors are triggered at the moment the connection between the devices is established, and the identification of the panel port, where the network device is connected, occurs by comparing the events of the sensor triggering and changing the status of the network device port. Such a system is not operative until the moment when connection is established.

There are method and system without the above disadvantages, described in the RU2490807 patent, in which a patch panel with sensors perceiving the signals of the reflectometer is presented. The disadvantage of this solution is the necessary presence of the reflectometer function in the network device.

### Summary of the invention

Thus, the object of the present invention is the development of such a means of cable connections monitoring with the use of Ethernet connection establishing signals, which will allow you to identify the patch panel port where the port of the network device is connected, without establishing the network connection, and not using a reflectometer.

To achieve disclosed technical result, a system of cable connections monitoring with the use of Ethernet connection establishing signals is proposed, comprising a network device, comprising ports for network connections; a patch panel with ports for cables connection; *characterized* in that it comprises at least one section of the cable path that is part of said patch panel and including one of said ports of the panel, and next to said section there located a device that uses Ethernet connection establishing signals; comprises a hardware and software system, which identifies the port of said patch panel, where the port of said network device is connected, applying said device, that uses Ethernet connection establishing signals.

In some alterations, the panel may comprise at least one data transmission sensor, changing the output signal when the data between network devices is transmitted via the panel port, corresponding to the sensor. The data transmission sensor can perceive electromagnetic radiation appeared as a side effect from data transmission signals, being transmitted via conductor, connected to pins 3 or 6 of the IEC 60603-7 connector of a port of said network device. For increasing the anti-interference capability, the data transmission sensor may comprise two inductance coils; one of them perceives radiation from data transmission signals, being transmitted via conductor, connected to pin 3 of the IEC 60603-7 connector of the network device port; the other inductance coil perceives radiation from data transmission signals, being transmitted via conductor, connected to pin 6 of the IEC 60603-7 connector of the network device port; and the coils are placed and connected between each other in such a way that the EMF phases of said coils differ by no more than 45 degrees.

In another alteration, the data transmission sensor can have electrical connection to pins 3 and 6 of the IEC 60603-7 connector of the corresponding patch panel port.

Said sensor can enable the hardware and software system to identify the port of the patch panel where the port of the network device is connected, comparing the time of change of the data transmission signal between network devices and the time of change of the data transmission sensor signal.

Another purpose of the data transmission sensor may be that the hardware and software system applies a device, that uses signals of Ethernet connection establishing, when with the use of a data transmission sensor it determines the absence of some data transmission signals in the cable path.

Sometimes a device, that uses signals of Ethernet connection establishing, can be connected to pins 1 and 2 of the IEC 60603-7 connector of the patch panel port and can transmit signals of Ethernet connection establishing to the cable path under the influence of the control signal from the hardware and software system. Wherein the device, that uses signals of Ethernet connection establishing, can transmit to the cable path the normal link pulses (NLP) signals to establish the 10Base-T connection or fast link pulses (FLP) signals.

The hardware and software system can identify the patch panel port, where the network device port is connected, by comparing the start time of Ethernet connection establishing signals transmission provided by the device that uses signals of Ethernet connection establishing, and the identifier of the cable path to which said signals are being transmitted, with the information about the network device port status change. Wherein information about the network device port status change may comprise at least the port identifier and/or the type of established Ethernet connection.

The patch panel may comprise infrared sensors, fixing the presence of a patch cord connector in the panel port and/or light indicators for its ports.

In another alteration, the device, that uses signals of Ethernet connection establishing, can not transmit but can perceive the signals of Ethernet connection establishing, which are being transmitted into the cable path by the network device. Wherein the device, that uses signals of Ethernet connection establishing, can perceive electromagnetic radiation appeared as a side effect from data transmitting signals, transmitted by the network device through a conductor connected to pin 3 or pin 6 of the IEC 60603-7 connector of the network device port. Alternatively, the device, that uses Ethernet connection establishing signals, can have an electrical connection to pins 3 and 6 of the IEC 60603-7 connector of the corresponding port of said patch panel.

In such cases, the hardware and software system can identify the patch panel port, where the port of the network device is connected, by changing the signal of Ethernet connection establishing of the network device port and comparing the said signal change with the change of the output signal from the device that uses signals of Ethernet connection establishing. The hardware and software system changes Ethernet connection establishing signal of the network device port by enabling/shutting down said port or by setting Ethernet Protocol parameters of the port.

Both the data sensor and the device, that uses Ethernet connection establishing signals, can be connected to the cable path using the connector.

In some cases, the data transmission sensor can perceive electromagnetic radiation appeared as a side effect by means of an inductance coil, that is connected to the signal amplifier via a connector. If two inductance coils are used in the sensor, then one terminal of each coil can be connected via the connector to the signal amplifier, and with the help of another terminal said coils are connected with each other.

An additional technical result can be achieved if the hardware and software system, with the help of a receiver that uses Ethernet connection establishing signals, checks for the presence of connection establishing signals in the cable path and, in the absence of such signals, decides that the cable path is not connected to the port of said network device. In other words, the proposed system allows determining the unconnected ports of the patch panel.

Finally, the device that uses Ethernet connection establishing signals, and data transmission sensor may have common structural elements, serving for connection to a cable path or for perceiving signals of electromagnetic radiation appeared as a side effect.

### Brief description of the drawings

In Fig. 1 the general scheme for the system of cable connections monitoring is shown.
In Fig. 2 typical port of an IEC 60603-7 network device is shown.

### Detailed description of the invention

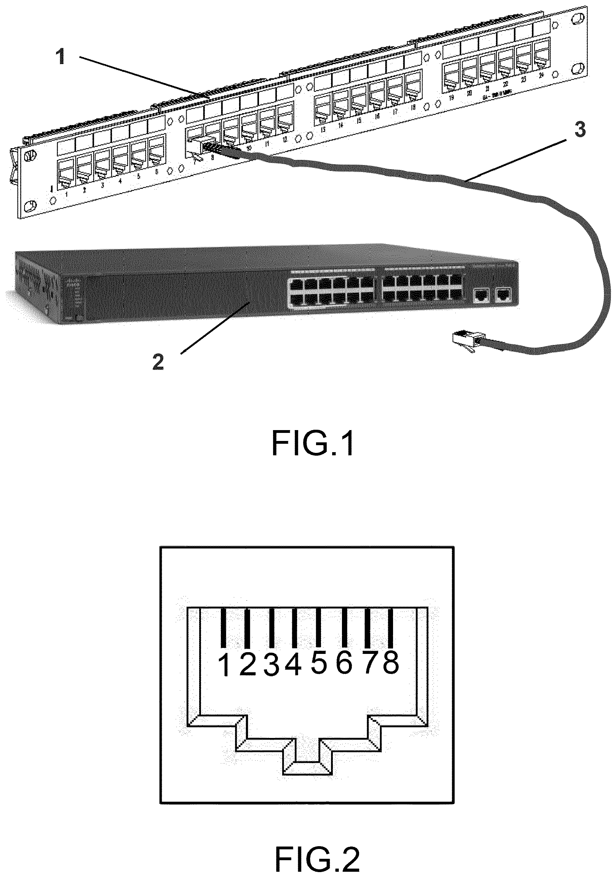

The system according to the present invention can be implemented in several alterations, which, nevertheless, are carried out in a similar way as shown in Fig. 1. The structure of the patch panel 1 can be different. The IEC 60603-7 (RJ45) connector of panel 1 port can be connected behind the front side of panel 1 to the IDC type connector (to which the cable from the workstation is connected) by means of conductors on the printed circuit board. In another alteration the port on the front side of panel 1 can be a KeyStone type connector, which with the help of a twisted pair behind the panel is connected to the similar KeyStone connector, which in its turn is connected to the cable from the workstation, terminated with a RJ45 plug (IEC 60603-7). In both alterations, a device, that uses signals of Ethernet connection establishing, and a data transmission signal sensor can be installed near the cable path section between the front connector and the rear connector (KeyStone or IDC).

The data transmission signal sensor is described, for example, in the RU74536 or RU2490807 patent and is used for determination of the presence of electromagnetic radiation appeared as a side effect (ERSE) near the patch panel port, caused by data transmission signals between the network device 2, in this case, the 100Base-T switch, and another network device, for example, a personal computer, connected by a cable to the panel 1 port on the reverse side. In another case, the transmission signals sensor can be electrically connected directly into the cable path. If such a sensor has a high input resistance, its effect on the useful signal will be negligible.

As described in the RU2313800 patent, at the moment of the electrical connection establishing between the personal computer and the commutation switch (including through the connection cable 3) data immediately begin to be transmitted, because, even in the absence of user data, the signal "Idle" is transmitted via the cable. Wherein information about the port status change is transmitted by the commutation switch via the network (in a standard way using SNMP traps, a log file or by reading the current status of the MAC-addresses table) to the hardware and software system. The hardware and software system, which is, in the general case, a network computer with the appropriate software, compares the connection establishing time and the sensor response time, and determines into which port of panel 1 the cable 3 connector, connecting the panel 1 port with the commutation switch 2 port, is connected.

But such system is not operative if the said personal computer is not connected to the network. That is why the device, that uses signals of Ethernet connection establishing, is added into the panel 1 structure.

For establishing Ethernet connection, any network device on pins 3 and 6 (Fig. 2) of the IEC 60603-7 connector forms signals of Ethernet connection establishing: normal link pulses signals (NLP, sometimes referred to as LIT) in the case of 10Base-T protocol, or auto-negotiation signals in the form of fast link pulse (FLP) signals for a faster type of Ethernet via twisted pair.

In one of alterations of the present invention implementation, FLP pulses generator, connected to the conductors of pins 1 and 2 of the connector can be used as a device, that uses signals of Ethernet connection establishing. FLP represent pulses of a positive polarity with duration of 100 nsec. If you install the receiver of such pulses on the conductors of pins 3 and 6 of the connector, and, with the use of a microprocessor, provide the process of auto-negotiation with the network device 2 port (according to the clause 28 of IEEE 802.3 standard), then you can link-up the port on network device 2.

But there is an easier method. It is enough to create a generator of single pulses with a duration of 100 nsec (for example, with the use of a separate microprocessor or Op-Amp) and repeat them on pins 1 and 2 of the panel front connector every 16 msec. The network device port (if it is connected to the panel port) will perceive this generator as a half-duplex 10Base-T device and link-up its own port in half-duplex 10Base-t mode. Wherein an SNMP trap message or a corresponding entry in the log file will be generated. As of today, the half-duplex 10Base-T mode is very rarely used, and for the hardware and software system will usually be enough to determine the port identifier from the SNMP message or log file information to match the cable path identifier, to which the NLP generator signal was injected, and the network device 2 port. And matching the NLP injection time and port link-up time makes identification even more reliable. Thus, the hardware and software system identifies the patch panel port, where the network device port is connected.

It is understood, that FLP or NLP signals injection into a cable path with an already established Ethernet connection can cause a failure. It is for this purpose that data transmission sensors should be used. First you need to check whether there is data in the cable path, and then inject the generator signals. It should be taken into account that not all data prevent the use of the generator. For example, FLP 100Base-T auto-negotiation signals also carry 16-bit data, but the use of a generator in a path with such signals will not lead to a failure. In addition, the generator should be connected to the cable path through switches, for example relays or analog keys, so as not to significantly change the parameters of the cable path in the passive (switched off) state of the generator.

In a further embodiment of the present invention an NLP/FLP signals receiver can be used as a device, that uses signals of Ethernet connection establishing. It can be implemented in the form of an inductance coil, which perceives the electromagnetic radiation appeared as a side effect above the conductor, connected to pin 3 or 6 of the panel port connector. The coil itself can be connected to the signal amplifier (comparator or JFET transistor). Alternatively, a comparator or JFET transistor (with high input impedance) can be electrically connected to pins 3 and 6. Wherein it is possible to use overvoltage protection, for example, protective diodes. Thus, the hardware and software system can determine the presence of connection establishing signals in the cable path. Besides, if the connection is already established (which can be understood from the state of the data transmission sensor), there is no need to monitor the connection establishing signals. The hardware and software system through terminal emulation via telnet or ssh protocols, or using SNMPSET can shutdown any port of the network device. It is obvious that the port of the network device in this case will stop transmitting connection establishing signals. And on one of the NLP/FLP signals receivers, such signals will be lost. By comparing the shutdown time of a specific port and the time of loss of signals in the cable path, the hardware and software system identifies the port of the patch panel, where the port of the network device is connected. Then you can enable the network device port again.

Another method to change the NLP/FLP signals is to enforce (again, by terminal emulation or SNMPSET) the network device port operation mode to 10Base-T. Thus, instead of FLP signals, NLP signals will be transmitted, which will change the output signal of the NLP/FLP signals receiver. Moreover, if to fix strictly the 100Base-T/1000Base-T/10GBase-T protocol parameters, for example into full duplex 100Base-T, then the FLP information bits also will change in comparison to the auto-negotiation mode.

To increase the sensitivity and noise immunity, the data transmission sensor may contain two induction coils, one of which perceives the electromagnetic radiation appeared as a side effect from one conductor, and the other one perceives the electromagnetic radiation appeared as a side effect from the other conductor of the same pair, which includes the first conductor, being installed in such a way that the EMF phases of these two coils differ by no more than 45 degrees. In other words, the EMF from the common-mode noise, simultaneously going through two conductors of one pair, will be subtracted, and from the data transmission signals - will be added.

Just like a device that uses Ethernet connection establishing signals, the data transmission sensor can be soldered to wires or mounted on a printed circuit board. In the latter case, it is convenient to connect the switch and the sensor using connectors. The sensor amplifier, for example JFET transistor BFT46, and the NLP/FLP receiver amplifier (generator) can be placed on a separate printed circuit board, and the inductance(s) can be soldered directly above the board track. Make tapping from terminals of the inductance and of the printed circuit board tracks (with the use of matching elements) onto pin connectors, for example PBS-5 sockets. A separate printed circuit board with amplifiers can be connected to the patch panel printed circuit board with the use of similar pinned plug PLS-4. Wherein in some cases it is convenient to use one branch from the cable path and one connector for tapping data transmission signals, and for FLP/NLP signals.

Similarly, the same inductance coil can be used for the perception of radiation both from data transmission signals, and from FLP/NLP signals. The spectrum of these signals differ strongly and it is not difficult to separate them.

If two coils are used for the data transmission sensor, then the coils are connected in series, and the remaining free terminals are lead to the connector.

Besides, it is useful to equip the patch panel with IR sensors, that are triggered at the connector connection to the panel port, and LED indicators above the panel ports.

If the hardware and software system will check, at some time interval, using the NLP/FLP signals receiver, for NLP/FLP signals presence in the cable path, then it will be possible to determine whether the corresponding patch panel port is connected to any port of a network. If there are no such signals, the patch panel port is either not connected anywhere, or is connected to the shut down port of the network device. It is possible to enable the shutdown ports temporarily, and determine where are they connected to. Wherein, with the help of IR sensors, it will be possible to track the patch cords that are connected by one end only into the patch panel and switch them off, which is usually required.

Although the present invention is described with references to specific embodiments, it is clear to those skilled in the art that these illustrative examples, in which various modifications can be made, do not limit the scope of the invention, determined by the attached claims only.

## Claims

1. System of cable connections monitoring with the use of Ethernet connection establishing signals, comprising:
- network device, comprising ports for network connections;
- patch panel with ports for cables connection:
***characterized* in that**:
- it comprises at least one section of the cable path, which is part of said patch panel and including one of said ports of the panel, and next to said section there is a device located, that uses Ethernet connection establishing signals;
- it comprises hardware and software system, which identifies the port of said patch panel, where the port of said network device is connected, applying said device, that uses Ethernet connection establishing signals.

2. The system of claim 1, ***characterized* in that** said panel comprises at least one data transmission sensor, changing the output signal when they transmit data between network devices via the panel port, corresponding to said sensor.

3. The system of claim 2, ***characterized* in that** said data transmission sensor perceives electromagnetic radiation appeared as a side effect from data transmission signals, being transmitted through a conductor, connected to pin 3 or pin 6 of the IEC 60603-7 standard connector of a port of said network device.

4. The system of claim 3, ***characterized* in that** said data transmission sensor comprises two inductance coils; one of them perceives radiation from data transmission signals, transmitted through a conductor, connected to pin 3 of the IEC 60603-7 standard connector of a port of said network device; the other inductance coil perceives radiation from data transmission signals, transmitted through a conductor, connected to pin 6 of said IEC 60603-7 standard connector of the network device port; and said coils are placed and connected between each other in such a way that the EMF phases of said coils differ by no more than 45 degrees.

5. The system of claim 2, ***characterized* in that** said data transmission sensor has electrical connection to pins 3 and 6 of the IEC 60603-7 standard connector of corresponding port of said patch panel.

6. The system of claim 2, ***characterized* in that** said hardware and software system identifies the port of said patch panel, where the port of said network device is connected, comparing the time of change of the data transmission signal between network devices and the time of signal change of said data transmission sensor.

7. The system of claim 2, ***characterized* in that** said hardware and software system applies said device, that uses signals of Ethernet connection establishing, when with the use of said data transmission sensor it determines the absence of some data transmission signals in the cable path.

8. The system of claim 1, ***characterized* in that** said device, that uses signals of Ethernet connection establishing, is connected to pins 1 and 2 of the IEC 60603-7 standard connector of said patch panel port and transmits signals of Ethernet connection establishing to the cable path under the influence of the control signal from said hardware and software system.

9. The system of claim 8, ***characterized* in that** said device, that uses signals of Ethernet connection establishing, transmits normal link pulses (NLP) signals to establish the 10Base-T connection or fast link pulses (FLP) signals to the cable path.

10. The system of claim 8, ***characterized* in that** said hardware and software system identifies the port of said patch panel, where the port of said network device is connected, by comparing the start time of Ethernet connection establishing signals transmission, provided by said device, that uses signals of Ethernet connection establishing, and the identifier of the cable path, to which said signals are being transmitted, with the information about port status change of said network device.

11. The system of claim 10, ***characterized* in that** said information about the network device port status change comprises at least the port identifier and/or the type of established Ethernet connection.

12. The system of claim 1, ***characterized* in that** said patch panel comprises infrared sensors, fixing the presence of a patch cord connector in the panel port and/or light indicators for their ports.

13. The system of claim 1, ***characterized* in that** said device, that uses signals of Ethernet connection establishing, perceives signals of Ethernet connection establishing, which are being transmitted into the cable path by said network device.

14. The system of claim 13, ***characterized* in that** said device, that uses signals of Ethernet connection establishing, perceives electromagnetic radiation appeared as a side effect from data transmission signals, transmitted through a conductor, connected, to pins 3 or 6 of the IEC 60603-7 standard connector of a port of said network device.

15. The system of claim 13, ***characterized* in that** said device, that uses Ethernet connection establishing signals, has an electrical connection to pins 3 and 6 of the IEC 60603-7 standard connector of the corresponding port of said patch panel.

16. The system of claim 13, ***characterized* in that** said hardware and software system identifies the port of said patch panel, where the port of said network device is connected, changing the signal of Ethernet connection establishing of a port of said network device and comparing the said signal change with the change of the output signal of said device, that uses signals of Ethernet connection establishing.

17. The system of claim 16, ***characterized* in that** said hardware and software system changes Ethernet connection establishing signal of a port of said network device by enabling/shutting down said port or by setting Ethernet Protocol parameters of said port.

18. The system of claim 5, ***characterized* in that** said data transmission sensor is connected to said path with the use of a connector.

19. The system of claim 8 or claim 15, ***characterized* in that** said device, that uses Ethernet connection establishing signals, is connected to the cable path with the use of a connector.

20. The system of claim 3, ***characterized* in that** said data transmission sensor perceives electromagnetic radiation appeared as a side effect by means of an inductance coil, that is connected to the signal amplifier via a connector.

21. The system of claim 3, ***characterized* in that** one terminal of each said coil is connected via the connector to the signal amplifier, and with the help of another terminal said coils are connected with each other.

22. The system of claim 13, ***characterized* in that** said hardware and software system, with the help of said device, that uses Ethernet connection establishing signals, checks for the presence of connection establishing signals in said cable path and, in the absence of such signals, decides that said cable path is not connected to the port of said network device.

23. The system of claim 2, ***characterized* in that** said device, that uses Ethernet connection establishing signals and said data transmission sensor have common structural elements, serving for connecting to a cable path or for receiving signals of electromagnetic radiation appeared as a side effect.
